# FASCICULE DE BREVET EUROPEEN

(11) **EP 3 840 063 B1**
(45) Date de publication et mention de la délivrance du brevet: **24.05.2023**
(21) Numéro de dépôt: 20209016.3
(22) Date de dépôt: 20.11.2020
(51) Int. Cl.: H01L 31/05

(54) **MODULE PHOTOVOLTAÏQUE AVEC RÉDUCTION DU DÉSÉQUILIBRE ÉLECTRIQUE**
FOTOVOLTAIKMODUL MIT REDUZIERUNG DES ELEKTRISCHEN UNGLEICHGEWICHTS
PHOTOVOLTAIC MODULE WITH REDUCTION OF ELECTRICAL IMBALANCE

(30) Priorité: 20.12.2019 FR 1915336
(43) Date de publication de la demande: 23.06.2021
(73) Titulaire: Commissariat à l'Energie Atomique et aux Energies Alternatives, 75015 Paris (FR)
(72) Inventeur: EYMARD, Julien, 38054 GRENOBLE CEDEX 09 (FR); BARTH, Vincent, 38054 GRENOBLE CEDEX 09 (FR); GERRITSEN, Eric, 38054 GRENOBLE CEDEX 09 (FR)
(74) Mandataire: Cabinet Camus Lebkiri

(56) Documents cités:
- EP-B1- 3 172 769
- US-A1- 2011 132 423
- US-A1- 2016 172 510

## Description

### DOMAINE TECHNIQUE DE L'INVENTION

Le domaine technique de l'invention est l'assemblage de cellules photovoltaïques sous forme de modules photovoltaïques et en particulier la réduction des pertes électriques au sein de ces modules.

### ARRIÈRE-PLAN TECHNOLOGIQUE DE L'INVENTION

Usuellement, la production d'énergie électrique au moyen de cellules photovoltaïques est réalisée par un assemblage de cellules photovoltaïques que l'on nomme module photovoltaïque. Un module photovoltaïque permet d'obtenir une tension ou un courant plus élevé qu'une cellule photovoltaïque seule, et notamment d'atteindre des puissances de l'ordre de la centaine de watt sous conditions standards d'éclairement.

Les modules photovoltaïques sont constitués de chaînes, plus communément appelées « *string »,* qui sont un assemblage de plusieurs cellules photovoltaïques connectées en série par des éléments d'interconnexion, typiquement des rubans ou des fils électriques. Ces chaînes sont également connectées en série pour former le module photovoltaïque.

Par exemple, un module comprenant 6 chaînes de 10 cellules photovoltaïques présente une tension de sortie égale à soixante fois la tension de seuil d'une cellule photovoltaïque (ex : 0,65 V) soit 39 V. Le courant produit par une cellule photovoltaïque peut atteindre 9 A sous une irradiance de 1000 W/m² d'où une puissance générée par le module photovoltaïque de 351 W.

Au moins deux architectures d'interconnexion sont connues pour former les modules photovoltaïques, l'une dite "standard" et l'autre dite "monolithique".

L'architecture d'interconnexion standard consiste à connecter des cellules photovoltaïques, monofaciales ou bifaciales, orientées dans le même sens et placées dans le même plan. Les éléments d'interconnexion, permettant de connecter la face arrière d'une cellule photovoltaïque avec la face avant de la cellule photovoltaïque adjacente, doivent serpenter d'un plan à l'autre du module.

L'architecture d'interconnexion standard requiert un espace important entre les cellules photovoltaïques pour laisser passer les éléments d'interconnexion, ce qui diminue le rapport entre la surface utile (c.-à-d. photosensible) et la surface totale du module photovoltaïque. De plus, les contraintes mécaniques imposées lors de cyclages thermiques fatiguent les éléments d'interconnexion et peuvent causer une défaillance du module photovoltaïque.

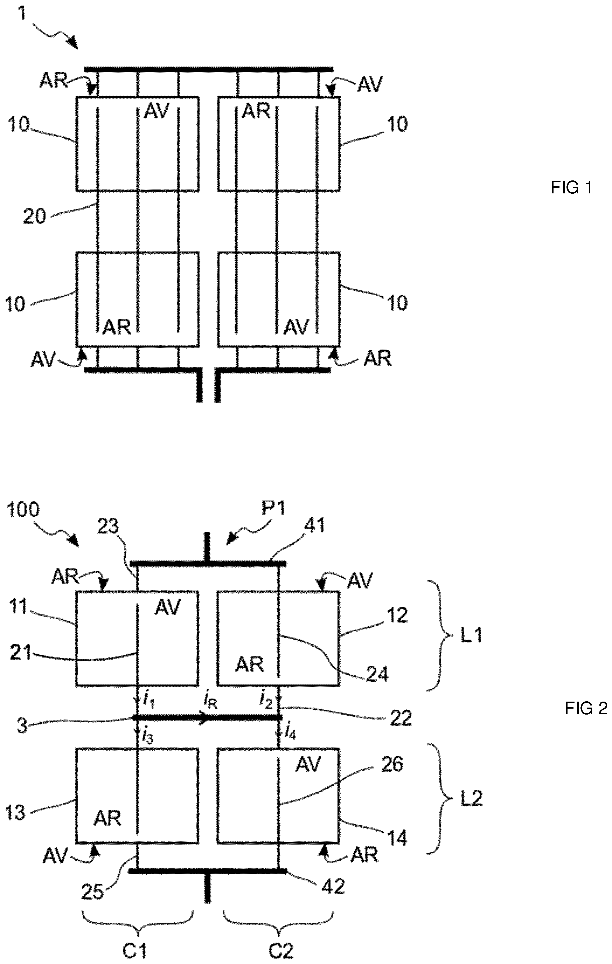

Au contraire, l'architecture d'interconnexion monolithique propose une solution à la conformation des éléments d'interconnexion. La figure 1 représente schématiquement un module photovoltaïque 1 agencé selon l'architecture d'interconnexion monolithique. Il comprend deux chaînes de cellules photovoltaïques 10 connectées électriquement en série, ces chaînes étant également connectées électriquement en série. La connexion de la face arrière AR d'une cellule photovoltaïque 10 avec la face avant AV de la cellule photovoltaïque 10 adjacente est réalisée dans un même plan. Pour ce faire, les faces avant AV et faces arrière AR des cellules photovoltaïques 10 sont alternées au sein de chaque chaîne. Les éléments d'interconnexion 20 reliant deux cellules photovoltaïques 10 adjacentes restent ainsi dans le même plan.

L'espace entre les cellules photovoltaïques étant libéré, les cellules photovoltaïques peuvent être rapprochées afin d'augmenter le rapport surface utile/surface totale. Toutefois, il convient de privilégier les cellules photovoltaïques bifaciales, dans lesquelles la face avant et la face arrière sont toutes les deux capables de capter le rayonnement solaire. De cette manière, les cellules photovoltaïques présentant la face arrière contribuent également à la production d'énergie électrique.

L'utilisation de cellules photovoltaïques bifaciales peut présenter un inconvénient car le rendement de conversion électrique et le courant électrique généré par chaque cellule photovoltaïque ne sont généralement les mêmes suivant l'orientation de la cellule. Le facteur de bifacialité rend compte de cette différence. Il peut être défini comme le rapport du courant au point de puissance maximale généré par la cellule photovoltaïque lorsque la face arrière est orientée vers la source d'éclairement par le courant au point de puissance maximale généré par la cellule photovoltaïque lorsque la face avant est orientée vers la source d'éclairement. Une cellule photovoltaïque dont les faces avant ou arrière sont indiscernables d'un point de vue de la génération de courant électrique a un facteur de bifacialité de 100 %. En revanche, un facteur de bifacialité inférieur à 100 % indique que la face arrière génère un courant moindre que celui de la face avant. Par convention, la face produisant le moins de courant est considérée comme la face arrière. Le facteur de bifacialité est considéré comme élevé lorsqu'il est supérieur à 75 %, typiquement 90 %.

Une cellule photovoltaïque présentant un facteur de bifacialité inférieur à 100 %, éclairée en face arrière et connectée en série au sein d'une chaîne, va produire un courant moindre que les autres cellules photovoltaïques et limiter le courant de la chaîne. Ainsi, la production énergétique du module photovoltaïque s'en trouve dégradée. La différence de production de courant électrique par une cellule moins performante au sein d'une chaîne de cellules performantes est appelée déséquilibre électrique ou « *electrical mismatch* » en anglais.

Le brevet EP3172769 B1 décrit un procédé de fabrication de module photovoltaïque permettant de réduire le déséquilibre électrique. Il met notamment en oeuvre la découpe asymétrique des cellules photovoltaïques en portions selon une superficie utile, calculée à partir du facteur de bifacialité. S'il permet de réduire le déséquilibre électrique, la mise en oeuvre d'un tel procédé complexifie la fabrication des modules photovoltaïques en ce qu'il comprend au moins des étapes de :
- calcul des superficies utiles des portions ;
- découpe asymétrique des cellules en portions ;
- réagencement des portions ; et
- interconnexion électrique des portions de tailles variables.

La demande de brevet US 2011/0132423 A1 décrit un module photovoltaïque monolithique.

### RÉSUME DE L'INVENTION

Un objectif de l'invention est de proposer une architecture électrique de module photovoltaïque réduisant le déséquilibre électrique de façon simple.

Selon un premier aspect de l'invention, on tend vers cet objectif en prévoyant un module photovoltaïque comportant un groupe de première, deuxième, troisième et quatrième cellules photovoltaïques comportant chacune une face avant et une face arrière opposée à la face avant, dans lequel la face avant de la première cellule photovoltaïque, la face arrière de la deuxième cellule photovoltaïque, la face arrière de la troisième cellule photovoltaïque et la face avant de la quatrième cellule photovoltaïque sont disposées dans un même plan, et dans lequel les première, deuxième, troisième et quatrième cellules photovoltaïques sont connectées par :
- au moins un premier élément conducteur, dit premier élément d'interconnexion, connectant la face avant de la première cellule photovoltaïque avec la face arrière de la troisième cellule photovoltaïque ;
- au moins un deuxième élément conducteur, dit deuxième élément d'interconnexion, connectant la face avant de la deuxième cellule photovoltaïque avec la face arrière de la quatrième cellule photovoltaïque ;

Le module photovoltaïque selon le premier aspect de l'invention est remarquable en ce qu'il comporte un troisième élément conducteur, dit élément de rééquilibrage, reliant le premier élément d'interconnexion et le deuxième élément d'interconnexion et en ce que les faces arrière des première et deuxième cellules photovoltaïques sont connectées entre elles et les faces avant des troisième et quatrième cellules photovoltaïques sont connectées entre elles.

Le courant parcourant l'élément de rééquilibrage est égal à la plus faible des différences de courants entre les première et troisième cellules photovoltaïques et entre les quatrième et deuxième cellules photovoltaïques. Ainsi, l'élément de rééquilibrage permet de dériver une partie de la différence de courant entre deux cellules photovoltaïques connectées par un même élément d'interconnexion vers une autre cellule photovoltaïque, capable de supporter cet excédent de courant. Le déséquilibre électrique est ainsi réduit et une cellule photovoltaïque moins performante limite d'une moindre manière le courant électrique d'une cellule photovoltaïque plus performante.

Lorsque plusieurs cellules photovoltaïques sont habituellement connectées en série, une cellule moins performante peut dissiper par effet Joule l'excédent de courant produit par les cellules les plus performantes, provoquant une augmentation de température de la cellule photovoltaïque moins performante. Cette augmentation de température peut provoquer l'endommagement de la cellule photovoltaïque la moins performante et de son matériau d'encapsulation. Comme ici une partie de l'excédent de courant est dérivée par l'élément de rééquilibrage, la cellule photovoltaïque moins performante ne dissipe plus la totalité du courant excédent. Ainsi, cette cellule photovoltaïque est en partie protégée par la présence de l'élément de rééquilibrage.

L'utilisation d'un élément de rééquilibrage évite de devoir couper les cellules photovoltaïques en portions de superficies différentes pour fabriquer le module photovoltaïque. Ainsi, la fabrication du module photovoltaïque selon le premier aspect de l'invention est simplifiée. Le module photovoltaïque peut être réalisé en utilisant des cellules photovoltaïques de tailles standards, par exemple des cellules photovoltaïques carrées ou pseudo-carrées de 156 mm par 156 mm.

Dans un mode de réalisation, les première, deuxième, troisième et quatrième cellules photovoltaïques sont sélectionnées de telle sorte que la somme du courant au point de puissance maximale généré par la première cellule photovoltaïque lorsque la face avant est éclairée et du courant au point de puissance maximale généré par la deuxième cellule photovoltaïque lorsque la face arrière est éclairée est sensiblement égale à la somme du courant au point de puissance maximale de la troisième cellule photovoltaïque lorsque la face arrière est éclairée et du courant au point de puissance maximale de la quatrième cellule photovoltaïque lorsque la face avant est éclairée.

Un avantage est de supprimer totalement le déséquilibre électrique et donc ses effets néfastes. Un autre avantage est que les cellules photovoltaïques les moins performantes ne limitent plus le courant total produit par le module photovoltaïque. Ce mode de réalisation présente également l'avantage d'être compatible avec des cellules photovoltaïques dont les courants aux points de puissance maximale sont tous différents.

Dans un mode de réalisation, les première, deuxième, troisième et quatrième cellules photovoltaïques sont bifaciales (le facteur de bifacialité des cellules photovoltaïques est strictement supérieur à 0).

Dans un mode de réalisation, les première et quatrième cellules photovoltaïques sont sélectionnées de telle sorte que les courants au point de puissance maximale soient sensiblement égaux lorsque leurs faces avant sont éclairées et les deuxième et troisième cellules photovoltaïques sont sélectionnées de telle sorte que les courants au point de puissance maximale soient sensiblement égaux lorsque leurs faces arrière sont éclairées

Dans un mode de réalisation, les première, deuxième, troisième et quatrième cellules photovoltaïques sont agencées en lignes et en colonnes, les première et deuxième cellules photovoltaïques appartenant à une première ligne, les troisième et quatrième cellules photovoltaïques appartenant à une seconde ligne, les première et troisième cellules photovoltaïques appartenant à une première colonne et les deuxième et quatrième cellules photovoltaïques appartenant à une deuxième colonne.

Dans un mode de réalisation, l'élément de rééquilibrage est disposé entre les première et troisième cellules photovoltaïques et entre les deuxième et quatrième cellules photovoltaïques.

Un avantage de la disposition précitée est pouvoir de rapprocher les première et deuxième cellules photovoltaïques et les troisième et quatrième cellules photovoltaïques (soit les cellules d'une même ligne), réduisant l'encombrement du module photovoltaïque dans la largeur (mesurée perpendiculairement aux éléments d'interconnexion).

Dans un mode de réalisation, l'élément de rééquilibrage est disposé sur les première et deuxième cellules photovoltaïques ou sur les troisième et quatrième cellules photovoltaïques.

Un avantage de la disposition précitée est de pouvoir rapprocher les première et troisième cellules photovoltaïques et les deuxième et quatrième cellules photovoltaïques (soit les cellules d'une même colonne), réduisant l'encombrement du module photovoltaïque dans la longueur (mesurée parallèlement aux éléments d'interconnexion).

Dans un mode de réalisation, l'élément de rééquilibrage comporte une première partie et une deuxième partie, la première partie connectant le premier élément d'interconnexion et la deuxième partie connectant le deuxième élément d'interconnexion, les première et deuxième parties étant connectée l'une à l'autre par un plot de connexion ou par une soudure.

L'avantage des parties distinctes de l'élément de rééquilibrage est de simplifier la connexion de chaque partie de l'élément de rééquilibrage sur les éléments d'interconnexion. La connexion des deux parties au moyen d'un plot de connexion ou d'une soudure évite la formation d'un coude ou limite la déformation des deux parties de l'élément de rééquilibrage.

Dans un mode de réalisation, les première, deuxième, troisième et quatrième cellules photovoltaïques sont de forme rectangulaire présentant un rapport longueur sur largeur compris entre 2 et 10, de préférence égal 2.

Un avantage est de mettre en oeuvre des cellules photovoltaïques issues d'un procédé de découpage de cellules photovoltaïques de pleine taille, comme des demi-cellules photovoltaïques. Des cellules photovoltaïques plus petites permettent également de diminuer le courant produit et ainsi diminuer les pertes résistives dans les interconnexions.

Dans un mode de réalisation, les première, deuxième, troisième et quatrième cellules photovoltaïques sont de forme pseudo-carrée et l'élément de rééquilibrage passe du premier plan à un deuxième plan parallèle au premier plan dans un espace central situé entre les première, deuxième, troisième et quatrième cellules photovoltaïques.

Disposer le coude ou le plot de connexion de l'élément de rééquilibrage dans l'espace laissé par les angles tronqués des cellules photovoltaïques permet de rapprocher les cellules photovoltaïques d'une même ligne et d'une même colonne. Ainsi, l'encombrement du module photovoltaïque est réduit.

Dans un mode de réalisation, le module photovoltaïque comprend :
- une pluralité de premiers éléments d'interconnexion connectant la face avant de la première cellule photovoltaïque avec la face arrière de la troisième cellule photovoltaïque ; et
- une pluralité de deuxièmes éléments d'interconnexion connectant la face avant de la deuxième cellule photovoltaïque avec la face arrière de la quatrième cellule photovoltaïque.

Un avantage de recourir à plusieurs premiers et deuxièmes éléments d'interconnexion est d'augmenter la répartition des points de collecte des courants générés sur les faces avant et arrière des cellules photovoltaïques.

Dans un mode de réalisation, le module photovoltaïque comprend un nombre entier N de premiers éléments d'interconnexion connectant la face avant de la première cellule photovoltaïque avec la face arrière de la troisième cellule photovoltaïque et le même nombre entier N de deuxièmes éléments d'interconnexion connectant la face avant de la deuxième cellule photovoltaïque avec la face arrière de la quatrième cellule photovoltaïque.

Dans un mode de réalisation, l'élément de rééquilibrage connecte une partie des premiers éléments d'interconnexion avec une partie des deuxièmes éléments d'interconnexion.

Connecter une partie des premiers et deuxièmes éléments d'interconnexion permet de diminuer la longueur de l'élément de rééquilibrage et donc de diminuer la quantité de matière nécessaire à la fabrication dudit élément de rééquilibrage.

Dans un mode de réalisation, l'élément de rééquilibrage connecte un nombre entier M de premiers éléments d'interconnexion avec le même nombre M de deuxièmes éléments d'interconnexion, M étant inférieur ou égal N.

Dans un mode de réalisation, chacun des premier, deuxième et troisième éléments conducteurs est constitué d'un fil conducteurs ou d'un ruban conducteur.

Les rubans conducteurs, de par leur section, acceptent des courants plus élevés et disposent également d'une meilleure résistance aux contraintes mécaniques. Les fils conducteurs nécessitent moins de matière quant à leur fabrication et sont également plus souples.

Dans un mode de réalisation, le module photovoltaïque comprend plusieurs groupes de première, deuxième, troisième et quatrième cellules photovoltaïques connectés électriquement en série.

La connexion série de deux groupes de cellules photovoltaïque permet, à courant égal, d'augmenter la tension de sortie, permettant d'adapter le module à son environnement de déploiement.

Dans un mode de réalisation, le module photovoltaïque comprend une cinquième et une sixième cellules photovoltaïques comportant chacune une face avant et une face arrière opposée à la face avant, dans lequel la face avant de la cinquième cellule photovoltaïque et la face arrière de la sixième cellule photovoltaïque sont disposées dans le même plan, les faces avant des cinquième et sixième cellules photovoltaïques sont connectées entre elles et les faces arrière des cinquième et sixième cellules photovoltaïques sont connectées entres elles aux faces avant des troisième et quatrième cellules photovoltaïques.

La combinaison de groupes comportant quatre ou six cellules photovoltaïques permet de former un module photovoltaïque final comportant un nombre paire (supérieur ou égal à 4) de cellules photovoltaïques. Ceci permet de constituer des modules photovoltaïques permettant d'atteindre des tensions élevées à courant identique.

Un deuxième aspect de l'invention concerne un procédé de fabrication d'un module photovoltaïque. Ce procédé de fabrication comporte les étapes suivantes :
- Former un groupe de première, deuxième, troisième et quatrième cellules photovoltaïques comportant chacune une face avant et une face arrière opposée à la face avant;
- Arranger les première, deuxième, troisième et quatrième cellules photovoltaïques telles que la face avant de la première cellule photovoltaïque, la face arrière de la deuxième cellule photovoltaïque, la face arrière de la troisième cellule photovoltaïque et la face avant de la quatrième cellule photovoltaïque soient disposées dans un même plan ;
- Connecter la face avant de la première cellule photovoltaïque avec la face arrière de la troisième cellule photovoltaïque au moyen d'au moins un premier élément conducteur, dit premier élément d'interconnexion ;
- Connecter la face avant de la deuxième cellule photovoltaïque avec la face arrière de la quatrième cellule photovoltaïque au moyen d'au moins un deuxième élément conducteur, dit deuxième élément d'interconnexion ;
- Connecter le premier élément d'interconnexion et le deuxième élément d'interconnexion au moyen d'un troisième élément conducteur, dit élément de rééquilibrage ;
- Connecter les faces arrière des première et deuxième cellules photovoltaïques ; et
- Connecter les faces avant des troisième et quatrième cellules photovoltaïques.

Dans un mode de réalisation, l'étape de connexion du premier élément d'interconnexion et du deuxième élément d'interconnexion comporte les sous-étapes suivantes :
- Prévoir un élément de rééquilibrage comportant une première partie et une deuxième parties distinctes ;
- Connecter la première partie de l'élément de rééquilibrage avec le premier élément d'interconnexion ;
- Connecter la deuxième partie de l'élément de rééquilibrage avec le deuxième élément d'interconnexion ;
- Connecter la première partie de l'élément de rééquilibrage avec la deuxième partie de l'élément de rééquilibrage au moyen d'un plot de connexion ou d'une soudure.

### BRÈVE DESCRIPTION DES FIGURES

Les figures sont présentées à titre indicatif et nullement limitatif de l'invention.
[FIG 1] représente schématiquement, en vue de dessus, un module photovoltaïque monolithique selon l'art antérieur.
[FIG 2] représente schématiquement, en vue de dessus, un premier mode de réalisation d'un module photovoltaïque selon le premier aspect de l'invention.
[FIG 3] représente schématiquement, en vue de dessus, un deuxième mode de réalisation du module photovoltaïque selon le premier aspect de l'invention.
[FIG 4] représente schématiquement, en vue de dessus, un troisième mode de réalisation du module photovoltaïque selon le premier aspect de l'invention.
[FIG 5] représente schématiquement, en vue de dessus, un quatrième mode de réalisation du module photovoltaïque selon le premier aspect de l'invention.
[FIG 6a] représente schématiquement, en vue de dessus, un cinquième mode de réalisation du module photovoltaïque selon le premier aspect de l'invention.
[FIG 6b] représente schématiquement, en vue de dessus, un sixième mode de réalisation du module photovoltaïque selon le premier aspect de l'invention.
[FIG 7a] montre un premier exemple de réalisation d'un élément de rééquilibrage appartenant au module photovoltaïque selon le premier aspect de l'invention.
[FIG 7b] montre un deuxième exemple de réalisation d'un élément de rééquilibrage appartenant au module photovoltaïque selon le premier aspect de l'invention.
[FIG 8] montre les caractéristiques I(V) d'un module photovoltaïque selon le troisième mode de réalisation de l'invention (symboles blancs) et d'un module photovoltaïque de référence sans élément de rééquilibrage (symboles noirs).
[FIG 9] représente schématiquement, en vue de dessus, un septième mode de réalisation du module photovoltaïque selon le premier aspect de l'invention.
[FIG 10] représente schématiquement, en vue de dessus, un huitième mode de réalisation du module photovoltaïque selon le premier aspect de l'invention.

Les figures sont présentées à titre indicatif et nullement limitatif de l'invention.

### DESCRIPTION DÉTAILLÉE

Dans la description qui suit, les qualificatifs de position absolue, tels que les termes "haut", "bas", "gauche", "droite", les qualificatifs de position relative, tels que les termes "dessus", "dessous", "supérieur", "inférieur" et les qualificatifs d'orientation, tels que les termes "horizontal", "vertical" font référence à l'orientation des figures, étant entendu que, dans la pratique, les modules photovoltaïques décrits peuvent être orientés différemment.

### Module photovoltaïque

Les figures 2 à 6b représentent différents modes de réalisation d'un module photovoltaïque 100 selon un premier aspect de l'invention. Le module photovoltaïque 100 est destiné à recevoir un rayonnement électromagnétique, tel que le rayonnement solaire, et à le convertir en énergie électrique.

Le module photovoltaïque 100 comporte une face avant et une face arrière, opposée à la face avant, toutes deux capables de capter le rayonnement électromagnétique. Ainsi, lorsque le module photovoltaïque 100 reçoit un rayonnement électromagnétique, une tension électrique V se créé entre ses bornes et il est génère un courant électrique I.

D'une manière commune à tous les modes de réalisation, le module photovoltaïque 100 comporte une première cellule photovoltaïque 11, une deuxième cellule photovoltaïque 12, une troisième cellule photovoltaïque 13 et une quatrième cellule photovoltaïque 14.

### Définitions face avant, courant au point de puissance maximale et rapport de bifacialité

De préférence, les cellules photovoltaïques 11-14 sont de même forme, de mêmes dimensions, par exemple carrées ou pseudo-carrées au format 156 mm x 156 mm, et d'un même type, par exemple à homojonction de silicium ou à hétérojonction de silicium.

Chacune des cellules photovoltaïques 11-14 comporte une face avant AV et une face arrière AR opposée à la face avant AV. Les cellules photovoltaïques 11-14 sont de préférence des cellules bifaciales. Autrement dit, leur face avant AV et leur face arrière AR sont toutes deux capables de capter le rayonnement électromagnétique.

Les faces avant AV et arrière AR comportent de préférence une pluralité d'électrodes de collecte du courant électrique généré, dits également doigts de collecte. Les électrodes de collecte sont également destinées à recevoir des éléments d'interconnexion afin de connecter les cellules photovoltaïques 11-14 entre elles au sein du module photovoltaïque 100.

La face avant d'une cellule photovoltaïque est définie comme étant la face qui permet à la cellule photovoltaïque de produire le plus grand courant au point de puissance maximale lorsqu'elle est éclairée, c'est-à-dire orientée vers une source de rayonnement. À l'inverse, la face arrière est définie comme étant la face qui permet à la cellule photovoltaïque de produire le plus petit courant au point de puissance maximale lorsqu'elle est orientée vers la source de rayonnement.

Par définition, le point de puissance maximale correspond au couple de tension et de courant permettant de maximiser la puissance délivrée par une cellule photovoltaïque, lorsqu'une des faces de la cellule photovoltaïque est éclairée dans des conditions standards (1000 W/m², 25 °C...) et la face opposée est masquée. Le point de puissance maximale est le point de fonctionnement recherché d'une cellule photovoltaïque ou d'un module photovoltaïque.

Le facteur de bifacialité d'une cellule photovoltaïque est défini comme le rapport du courant au point de puissance maximale généré par la cellule photovoltaïque lorsque la face avant est orientée vers la source de rayonnement par le courant au point de puissance maximale généré par la cellule photovoltaïque lorsque la face arrière est orientée vers la source de rayonnement. Le facteur de bifacialité est compris entre 0 % et 100 %. Il est considéré comme élevé lorsqu'il est supérieur à 75 %, typiquement 90 %.

### Agencement des cellules photovoltaïques

Dans le mode de réalisation des figures 2 à 6b, les cellules photovoltaïques 11-14 forment un groupe et sont agencées de manière alternée de sorte que la face avant AV de la première cellule photovoltaïque 11, la face arrière AR de la deuxième cellule photovoltaïque 12, la face arrière AR de la troisième cellule photovoltaïque 13 et la face avant AV de la quatrième cellule photovoltaïque 14 sont disposées dans un même premier plan P1. Ainsi, la face arrière AR de la première cellule photovoltaïque 11, la face avant AV de la deuxième cellule photovoltaïque 12, la face avant AV de la troisième cellule photovoltaïque 13 et la face arrière AR de la quatrième cellule photovoltaïque 14 sont disposées dans un second plan P2, parallèle au premier plan P1. Le premier plan P1 correspond à la face avant du module photovoltaïque 100 tandis que le second plan P2 correspond à sa face arrière.

Les cellules photovoltaïques 11-14 sont de préférence agencées en lignes L1, L2 et en colonnes C1, C2 (voir Fig.2). Les première et deuxième cellules photovoltaïques 11, 12 appartiennent à une première ligne L1 dite « ligne supérieure » et les troisième et quatrième cellules photovoltaïques 13, 14 appartiennent à une deuxième ligne L2 dite « ligne inférieure ». Les première et troisième cellules photovoltaïques 11, 13 appartiennent à une première colonne C1 « dite colonne gauche » et les deuxième et quatrième cellules photovoltaïques 12, 14 appartiennent à une deuxième colonne C2 « dite colonne droite ».

L'espacement entre la ligne supérieure L1 et la ligne inférieure L2 est de préférence inférieure à 15 mm. L'espacement entre la colonne gauche C1 et la colonne droite C2 est de préférence inférieure à 10 mm.

### Interconnexion des cellules photovoltaïques

Toujours en référence aux figures 2 à 6b, le module photovoltaïque 100 comporte en outre au moins un premier élément conducteur 21 et au moins un deuxième élément conducteur 22, appelés également premier et deuxième éléments d'interconnexion.

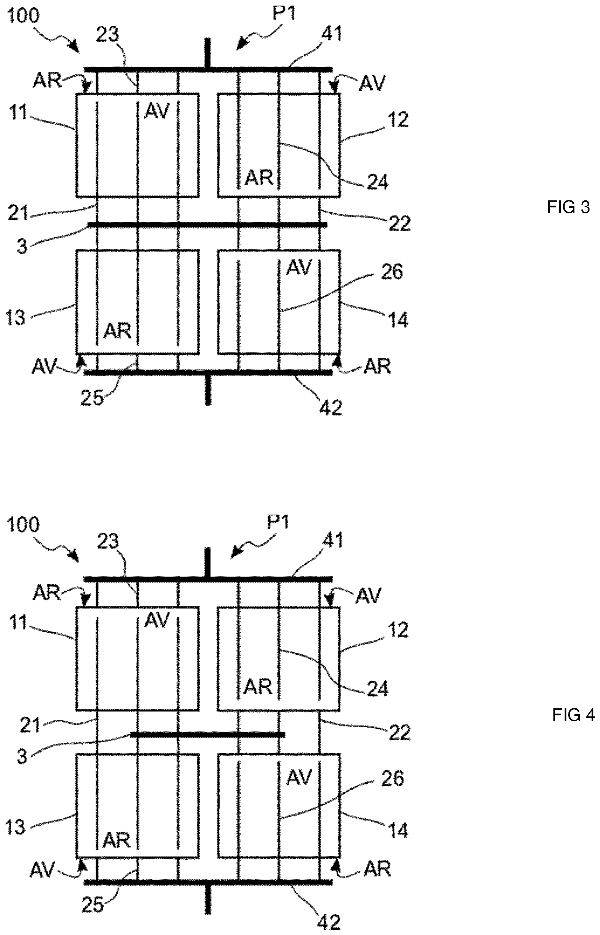

Dans le mode de réalisation de la figure 2, le module photovoltaïque 100 comprend un seul premier élément d'interconnexion 21 et un seul deuxième élément d'interconnexion 22, alors que dans les modes de réalisation des figures 3 à 6b, le module photovoltaïque 100 comprend plusieurs premiers éléments d'interconnexion 21 et plusieurs deuxièmes éléments d'interconnexion 22, par exemple au nombre de 3 chacun. Les premiers et deuxièmes éléments d'interconnexion 21-22 ont par exemple la forme d'un ruban ou d'un fil conducteur. Le ruban conducteur présente généralement une section rectangulaire alors que le fil conducteur présente une section circulaire.

Chaque premier élément d'interconnexion 21 connecte la face avant AV de la première cellule photovoltaïque 11 avec la face arrière AR de la troisième cellule photovoltaïque 13. Le premier élément d'interconnexion 21 s'étend de préférence sur le premier plan P1, à partir du voisinage du bord supérieur de la première cellule photovoltaïque 11 jusqu'au voisinage du bord inférieur de la troisième cellule photovoltaïque 13, le long de la face avant AV de la première cellule photovoltaïque 11 et de la face arrière AR de la troisième cellule photovoltaïque 13, en enjambant l'espacement entre les lignes supérieure et inférieure L1, L2.

Par "voisinage d'un bord", on entend à une distance du bord inférieure à 5 % de la longueur de la cellule, la longueur étant la dimension mesurée parallèlement aux éléments d'interconnexion 21, 22.

De la même manière, chaque deuxième élément d'interconnexion 22 connecte la face avant AV de la deuxième cellule photovoltaïque 12 avec la face arrière AR de la quatrième cellule photovoltaïque 14. Le deuxième élément d'interconnexion 22 s'étend de préférence sur le deuxième plan P2, à partir du voisinage du bord supérieur de la deuxième cellule photovoltaïque 12 jusqu'au voisinage du bord inférieur de la quatrième cellule photovoltaïque 14, le long de la face avant AV de la deuxième cellule photovoltaïque 12 et de la face arrière AR de la quatrième cellule photovoltaïque 14, en enjambant l'espacement entre les lignes supérieure et inférieure L1, L2.

Dans les modes de réalisation des figures 3, 4, 6a-6b, les premiers et deuxièmes éléments d'interconnexion 21, 22 sont distribués latéralement afin d'augmenter la répartition des points de collecte des courants générés sur les faces avant AV et arrière AR des cellules photovoltaïques 11-14.

### Élément de rééquilibrage

Le module photovoltaïque 100 comprend en outre un troisième élément conducteur 3, dit élément de rééquilibrage, par exemple sous la forme d'un ruban ou d'un fil conducteur, reliant électriquement au moins un des premiers éléments d'interconnexion 21 avec au moins un des deuxièmes éléments d'interconnexion 22.

### Connexion parallèle

À l'inverse de l'architecture monolithique classique illustrée par la figure 1, une connexion parallèle au sein du module photovoltaïque 100 est réalisée en connectant les faces arrière AR des première et deuxième cellules photovoltaïques 11, 12 entre elles et en connectant les faces avant AV des troisième et quatrième cellules photovoltaïques 13, 14 entre elles.

La face arrière AR de la première cellule photovoltaïque 11 peut être connectée à la face arrière AR de la deuxième cellule photovoltaïque 12 au moyen de :
- un ou plusieurs quatrièmes éléments conducteurs 23 disposés sur la face arrière AR de la première cellule photovoltaïque 11 ;
- un ou plusieurs cinquièmes éléments conducteurs 24 disposés sur la face arrière AR de la deuxième cellule photovoltaïque 12 ; et
- un sixième élément conducteur 41, dit élément d'entrée et qui connecte les quatrièmes et cinquièmes éléments conducteurs 23, 24.

De la même manière, la face avant AV de la troisième cellule photovoltaïque 13 peut être connectée à la face avant AV de la quatrième cellule photovoltaïque 14 au moyen de :
- un ou plusieurs septièmes éléments conducteurs 25 disposés sur la face avant AV de la troisième cellule photovoltaïque 13 ;
- un ou plusieurs huitièmes éléments conducteurs 26 disposés sur la face avant AV de la quatrième cellule photovoltaïque 14 ;
- un neuvième élément conducteur 42, dit élément de sortie et qui connecte les septièmes et huitièmes éléments conducteurs 25, 26.

Les quatrièmes, cinquièmes, septièmes et huitièmes éléments conducteurs 23, 24, 25, 26 ont par exemple la forme d'un ruban ou d'un fil conducteur. Les éléments d'entrée et de sortie 41, 42 ont de préférence la forme d'un ruban conducteur.

### Réduction du déséquilibre électrique

La figure 2 représente schématiquement les courants i₁ et i₂ traversant les première et deuxième cellules photovoltaïques 11, 12, fléchés entrants dans l'élément de rééquilibrage 3, et les courants is et i₄ traversant les troisième et quatrième cellules photovoltaïques 13, 14, fléchés sortants de l'élément de rééquilibrage 3. Du fait de leur orientation (face avant AV vers la source d'éclairement), les première et quatrième cellules photovoltaïques 11, 14 supportent davantage de courant que les deuxième et troisième cellules photovoltaïques 12, 13 (face arrière AR vers la source d'éclairement). Dans la convention adoptée sur la figure 2, l'élément de rééquilibrage 3 dérive une partie au moins de l'excédent du courant généré par la première cellule photovoltaïque 11, que ne peut supporter la troisième cellule photovoltaïque 13, vers la quatrième cellule photovoltaïque 14. Le courant I_{R} parcourant l'élément de rééquilibrage 3 s'ajoute ainsi au courant i₂ généré par la deuxième cellule photovoltaïque. Il est égal à la plus petite valeur entre la différence des courants générés par les première et troisième cellules photovoltaïques 11, 13 et la différence des courants générés par les quatrième et deuxième cellules photovoltaïques, soit i_{R} = min {i₁ - i₃ ; i₄ - i₂}.

Ainsi, grâce à l'élément de rééquilibrage 3, une cellule photovoltaïque peu performante (telle que la troisième cellule photovoltaïque 13) limite moins le courant électrique de la cellule photovoltaïque plus performante (ici la première cellule photovoltaïque 11) à laquelle elle est connectée par l'élément d'interconnexion. Une partie de l'excédent de courant étant dérivé, la cellule photovoltaïque moins performante ne dissipe plus la totalité d'excédent d'énergie. Elle subit alors moins d'échauffement et moins de fatigue. L'élément de rééquilibrage 3 procure par ailleurs au module photovoltaïque une meilleure stabilité thermodynamique.

Dans un exemple de module photovoltaïque 100, la première cellule photovoltaïque 11 peut générer au maximum un courant de 9 A, la deuxième cellule photovoltaïque 12 peut générer au maximum 3 A, la troisième cellule photovoltaïque 13 peut générer au maximum 4 A et la quatrième cellule photovoltaïque 14 peut générer au maximum 7 A. Sans élément de rééquilibrage 3, les courants circulant dans les premier(s) et deuxième(s) éléments d'interconnexion 21, 22 sont limités par les cellules photovoltaïques générant les plus bas courant, c'est-à-dire respectivement 4 A et 3 A. Le courant produit par le module photovoltaïque est alors de 7 A. Dans le module photovoltaïque 100, un courant de rééquilibrage i_{R} de 4 A circule dans l'élément de rééquilibrage 3. La deuxième cellule photovoltaïque 12 ne limite plus le courant de la quatrième cellule photovoltaïque 14 et la première cellule photovoltaïque 11 délivre également plus de courant qu'en l'absence de l'élément de rééquilibrage (8 A au lieu de 4 A). La somme des courants produit par le module photovoltaïque est de 11 A, supérieur au courant produit sans élément de rééquilibrage 3.

À titre d'exemple, une comparaison réalisée par les inventeurs entre un module photovoltaïque de référence et un module photovoltaïque 100 selon le premier aspect de l'invention montre une augmentation du courant au point de puissance maximale et de la puissance totale délivrée en faveur du module photovoltaïque 100.

Les modules photovoltaïques de référence et selon l'invention comportent chacun un groupe de cellules photovoltaïques bifaciales, agencées de la façon décrite précédemment, ayant chacune un facteur de bifacialité de 75,71 %, délivrant un courant au point de puissance maximale de 8,695 A lorsque la face avant est éclairée et un courant au point de puissance maximale de 6,616 A lorsque la face arrière est éclairée. Les cellules photovoltaïques au sein de chaque module photovoltaïque sont d'une part connectées en série au moyen de 18 premiers éléments d'interconnexion 21 et 18 deuxièmes éléments d'interconnexion 22 et d'autre part connectées en parallèle (par 4x18 éléments conducteurs 23-26 et les éléments d'entrée et de sortie 41, 42). À la différence du module photovoltaïque de référence, le module photovoltaïque 100 selon l'invention comporte un élément de rééquilibrage 3 connectant tous les premiers et deuxièmes éléments d'interconnexion 21, 22.

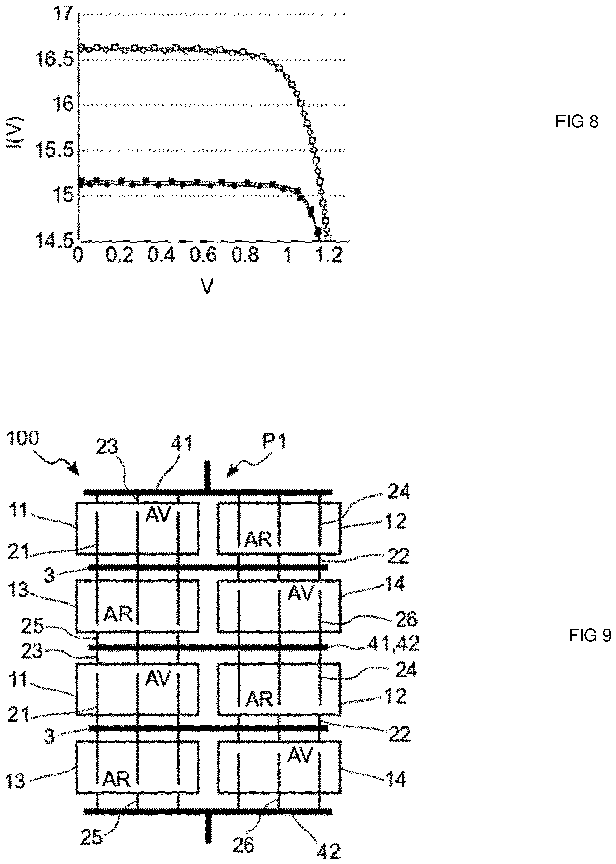

Les caractéristiques I-V des modules photovoltaïques de référence et selon l'invention sont représentées par la figure 8. Les symboles noirs représentent les caractéristiques I-V du module photovoltaïque de référence lorsque sa face avant (carrés noirs) ou sa face arrière (ronds noirs) est éclairée. Les symboles blancs représentent la caractéristique I-V du module photovoltaïque 100 selon l'invention lorsque sa face avant (carrés blancs) ou sa face arrière (ronds blancs) est éclairée. Ainsi, le courant au point de puissance maximale du module photovoltaïque de référence est de 14,34 A lorsqu'il reçoit un rayonnement lumineux en face avant et de 14,29 A en face arrière. Le courant au point de puissance maximale du module photovoltaïque 100 selon l'invention est de 15,19 A lorsqu'il reçoit un rayonnement en face avant et de 15,18 A en face arrière, soit une augmentation du courant au point de puissance maximale supérieure à 6 % dans chaque cas. La puissance délivrée par le module photovoltaïque de référence est de 16,85 W lorsqu'il reçoit un rayonnement en face avant et de 16,80 W en face arrière. La puissance délivrée par le module photovoltaïque 100 selon l'invention est de 17,59 W lorsqu'il reçoit un rayonnement en face avant et de 17,57 W en face arrière, soit une augmentation de la puissance délivrée supérieure à 4,4 % dans chaque cas.

Le module photovoltaïque 100 selon le premier aspect de l'invention présente ainsi un facteur de bifacialité proche de 100 %, typiquement supérieur à 95 %, quelle que soit le facteur de bifacialité des cellules photovoltaïques qui le composent. Grâce à l'élément de rééquilibrage, le déséquilibre électrique entre les cellules est réduit et la puissance délivrée est augmentée. Le module photovoltaïque 100 bénéficie par ailleurs des avantages de l'architecture monolithique (interconnexion des cellules plus facile et ratio surface utile/surface totale amélioré).

### Tri et sélection des cellules photovoltaïques

Afin de minimiser les pertes électriques par effet Joule au sein d'une cellule photovoltaïque peu performante, il est préférable de procéder à une sélection (ou tri) des cellules photovoltaïques 11-14, préalablement à la fabrication du module photovoltaïque 100. La sélection est de préférence réalisée en comparant les courants aux points de puissance maximale des cellules photovoltaïques 11-14.

De façon avantageuse, les cellules photovoltaïques 11-14 sont choisies de sorte que la somme du courant au point de puissance maximale généré par la première cellule photovoltaïque 11 lorsque la face avant AV est éclairée et du courant au point de puissance maximale généré par la deuxième cellule photovoltaïque 12 lorsque la face arrière AR est éclairée est sensiblement égale à la somme du courant au point de puissance maximale de la troisième cellule photovoltaïque 13 lorsque la face arrière AR est éclairée et du courant au point de puissance maximale de la quatrième cellule photovoltaïque 14 lorsque la face avant AV est éclairée. Ainsi, lors du fonctionnement du module, la somme des courants i₁ + i₂ traversant les première et deuxième cellules photovoltaïques 11, 12, (courants entrants dans l'élément de rééquilibrage 3) est sensiblement égale à la somme des courants i₃ + i₄ traversant les troisième et quatrième cellules photovoltaïques 13, 14 (courants sortants de l'élément de rééquilibrage 3), soit i₁ + i₂ = i₃ + i₄. Le déséquilibre électrique est alors presque totalement supprimé et des cellules photovoltaïques 11-14 dont les courants aux points de puissance maximale sont tous différents peuvent être utilisées.

Par "sensiblement égal", on entend une différence entre courants ou sommes de courants inférieure à 5 %.

Les procédés de fabrications de cellules photovoltaïques actuels permettent de réaliser des cellules photovoltaïques 11-14 dont les courants aux points de puissance maximale et les rapports de bifacialité sont sensiblement égaux (à 5 % près). Ainsi, les première et quatrième cellules photovoltaïques 11, 14 peuvent être sélectionnées de telles sorte que leurs courants aux points de puissance maximale sont égaux (lorsque leurs faces avant AV sont éclairées) et les deuxième et troisième cellules photovoltaïques 12, 13 peuvent être sélectionnées de telles sorte que les courants aux points de puissance maximale sont égaux (lorsque leurs faces arrière AR sont éclairées).

### Disposition de l'élément de rééquilibrage

Dans le mode de réalisation des figures 2 à 4 et 6b, l'élément de rééquilibrage 3 est disposé entre les première et troisième cellules photovoltaïques 11, 13 et entre les deuxième et quatrième cellules photovoltaïques 12, 14, autrement dit entre les lignes supérieure et inférieure L1, L2. L'élément de rééquilibrage s'étend de préférence parallèlement aux bords inférieurs des première et deuxième cellules photovoltaïques 11, 12 et aux bords supérieurs des troisième et quatrième cellules photovoltaïques 13, 14.

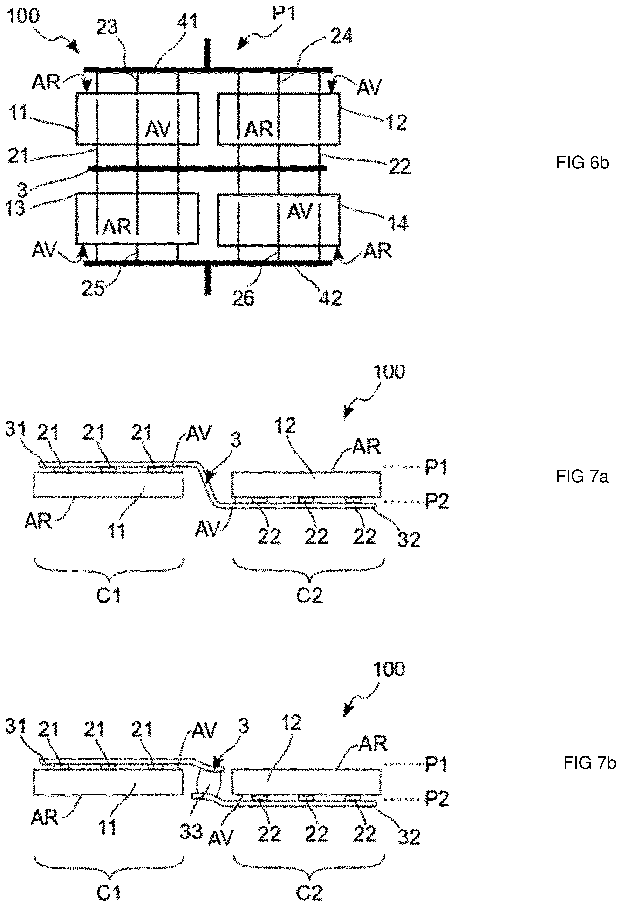

Dans un premier exemple de réalisation représenté par la figure 7a, compatible avec tous les modes de réalisation du module photovoltaïque 100, l'élément de rééquilibrage 3 comprend une première partie 31 et une deuxième partie 32. La première partie 31 s'étend sur le premier plan P1 pour connecter le(s) premier(s) élément(s) d'interconnexion 21 et la deuxième partie 32 s'étend sur le deuxième plan P2 pour connecter le(s) deuxième(s) élément(s) d'interconnexion 22. Entre les première et deuxième parties 31, 32, l'élément de rééquilibrage 3 change de plan en formant un coude.

Dans un deuxième exemple de réalisation de la figure 7b, également compatible avec tous les modes de réalisation du module photovoltaïque 100, les première et deuxième parties 31, 32 de l'élément de rééquilibrage 3 peuvent être initialement distinctes et, une fois la connexion avec les premiers et deuxièmes éléments d'interconnexion 21, 22 réalisée, connectées au moyen d'un plot de connexion 33. Le plot de connexion 33 peut être constitué d'un adhésif conducteur. Alternativement, les première et deuxième parties 31, 32 sont connectées, sans nécessité d'un plot de connexion, par une soudure.

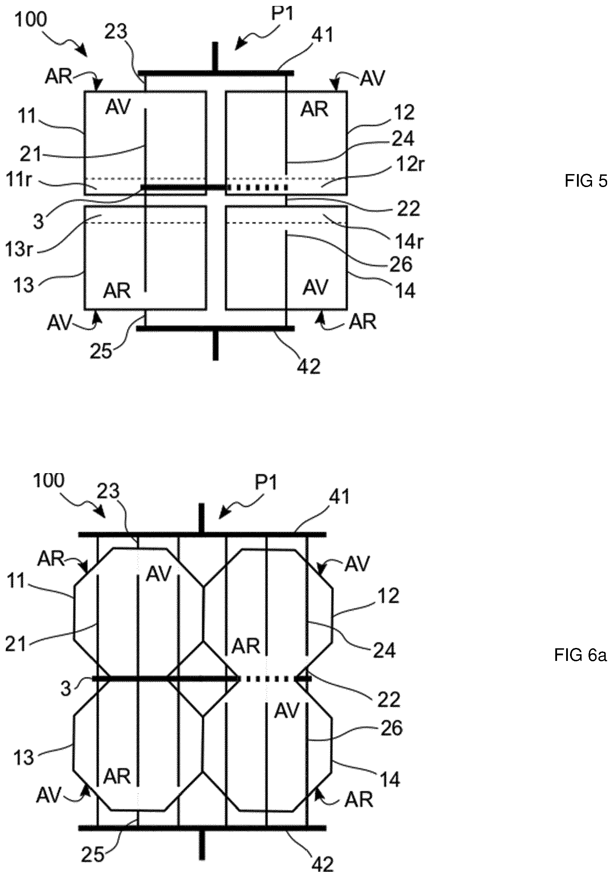

Dans les deux cas, le changement de plan de l'élément de rééquilibrage 3 est avantageusement localisé entre les colonnes gauche et droite C1, C2. Ainsi, les bords inférieurs des première et deuxième cellules photovoltaïques 11, 12 sont en vis-à-vis sans gêne avec les bords supérieurs des troisième et quatrième cellules photovoltaïques 13, 14. Cet espace dégagé permet de rapprocher la première cellule photovoltaïque 11 de la troisième cellule photovoltaïque 13 et la deuxième cellule photovoltaïque 12 de la quatrième cellule photovoltaïque 14, diminuant ainsi l'espacement entre les lignes supérieure et inférieure L1, L2, comme cela est par exemple illustré sur la figure 6a. L'encombrement du module photovoltaïque 100 est ainsi réduit.

Dans le mode de réalisation de la figure 5, les cellules photovoltaïques 11-14, par exemple issues d'une étape de découpage de cellules photovoltaïques de pleine taille, comportent des zones 11r, 12r, 13r, 14r le long d'au moins un de leurs bords, dites zones de recombinaison, dans lesquelles le taux de recombinaison des porteurs de charges photogénérés est élevé. Dans ce cas, il est préférable de disposer l'élément de rééquilibrage 3 sur ces zones de recombinaison 11r-14r afin de minimiser l'encombrement du module photovoltaïque 100 en ayant un impact moindre sur la production électrique du module photovoltaïque 100. Dans ce mode de réalisation, les cellules photovoltaïques 11-14 sont disposées de sorte que les zones de recombinaison 11r-14r soient adjacentes de l'espacement entre les lignes supérieure et inférieure L1, L2. Ainsi, l'élément de rééquilibrage s'étend dans le premier plan P1 sur la première cellule photovoltaïque 11 et dans le second plan P2 sur la deuxième cellule photovoltaïque 12. Alternativement, l'élément de rééquilibrage s'étend dans le premier plan P1 sur la troisième cellule photovoltaïque 13 et dans le second plan P2 sur la quatrième cellule photovoltaïque 14.

### Longueur de l'élément de rééquilibrage

Dans les modes de réalisation des figures 3, 6a et 6b, le module photovoltaïque 100 comporte plusieurs premiers éléments d'interconnexion 21 et plusieurs deuxièmes éléments d'interconnexion 22. En outre, l'élément de rééquilibrage 3 connecte la totalité des premiers et deuxièmes éléments d'interconnexion.

Dans le mode de réalisation de la figure 4, l'élément de rééquilibrage 3 connecte une partie des premiers éléments d'interconnexion 21 avec une partie des deuxièmes éléments d'interconnexion 22. Le nombre entier M d'éléments d'interconnexion 21, 22 connectés par l'élément de rééquilibrage 3, parmi un nombre N d'éléments d'interconnexion 21, 22, peut dépendre de la différence entre les courants aux points de puissance maximale générés par les cellules photovoltaïques connectées par un même élément d'interconnexion 21, 22. Lorsque la différence des courants est faible, la longueur de l'élément de rééquilibrage 3 peut être réduite, une partie des courants de rééquilibrage circulant au sein de la cellule photovoltaïque. Ainsi, le nombre M peut être choisi inférieur à N et au moins égal à 1.

À titre d'exemple, considérons un module photovoltaïque 100 comportant des cellules photovoltaïques 11-14 bifaciales dont le rapport I_{AR}/I_{AV} est égal à 75 %, connectées par cinq premiers et cinq deuxièmes éléments d'interconnexion 21, 22. L'élément de rééquilibrage 3 connecte de préférence 2 premiers éléments d'interconnexion 21 avec 2 deuxièmes éléments d'interconnexion 22.

Afin de limiter la longueur de l'élément de rééquilibrage 3, les M premiers et deuxièmes éléments d'interconnexion 21,22 connectés sont de préférence les plus proches de l'espacement entre les colonnes gauche et droite C1, C2. L'intérêt de limiter le nombre de premiers et deuxièmes éléments d'interconnexion 21,22 connectés par l'élément de rééquilibrage 3 est de diminuer la quantité de matière nécessaire à la réalisation dudit élément de rééquilibrage 3, notamment la quantité d'alliage fusible pour des fils ou des rubans métalliques recouverts d'alliage fusible.

### Largeur de l'élément de rééquilibrage.

Si le courant de rééquilibrage est faible, il est possible de diminuer la section de l'élément de rééquilibrage 3. Ceci permet également de diminuer la quantité de matière nécessaire à la réalisation dudit élément de rééquilibrage 3.

### Formats des cellules photovoltaïques

Les cellules photovoltaïques 11-14 peuvent présenter différentes formes.

Dans les modes de réalisation des figures 3 à 5, les cellules photovoltaïques 11-14 sont de forme carrée, par exemple au format standard 156 mm x 156 mm.

Selon le mode de réalisation de la figure 6a, les cellules photovoltaïques 11-14 sont de forme pseudo-carrée, c'est-à-dire de forme carrée avec les angles tronqués. Les cellules photovoltaïques pseudo-carrée offrent l'avantage de libérer un espacement entre les cellules photovoltaïques 11-14 lorsque les cellules photovoltaïques 11-14 sont agencées selon des lignes supérieure inférieure L1, L2 et des colonnes gauche et droite C1, C2. Cet espacement peut accueillir le coude formé par l'élément de rééquilibrage 3 (voir figure 7a) ou le plot de connexion 33 (voir figure 7b). Ainsi, les cellules photovoltaïques 11-14 peuvent être juxtaposées réduisant l'encombrement du module photovoltaïque 100.

Selon le mode de réalisation de la figure 6b, les cellules photovoltaïques 11-14 sont de forme rectangulaire et présentent un rapport longueur par largeur compris entre deux et dix. Tel est le cas lorsque les cellules photovoltaïques 11-14 sont des portions de cellules (aussi appelées « sous-cellules ») obtenues par découpage de cellules photovoltaïques entières (dite « de pleine taille »). Par exemple, les cellules photovoltaïques 11-14 sont des demi-cellules photovoltaïques et présentent un rapport longueur par largeur égal à deux. Les demi-cellules photovoltaïques 11-14 génèrent, à tension égale, la moitié du courant électrique généré par la cellule photovoltaïque entière. Ainsi, l'utilisation de demi-cellules photovoltaïques permet d'adapter la tension et le courant de sortie du module photovoltaïque 100. Par exemple, un module photovoltaïque 100 comportant des demi-cellules photovoltaïques 11-14 conserve la même tension aux bornes qu'un module photovoltaïque 100 comprenant des cellules photovoltaïques 11-14 entières mais son courant électrique est réduit de moitié.

### Assemblage de groupes de cellules photovoltaïques

Dans le mode de réalisation de la figure 9, le module photovoltaïque 100 comporte une pluralité de groupes de première, deuxième, troisième et quatrième cellules photovoltaïques 11-14, par exemple des demi-cellules photovoltaïques 11-14, chaque groupe étant connecté selon un mode de réalisation décrit précédemment. Les groupes de cellules sont connectés en série, par exemple en utilisant un seul élément conducteur pour former simultanément l'élément de sortie 42 d'un groupe avec l'élément d'entrée 41 du groupe suivant. Autrement dit, les éléments d'entrée et de sortie 41, 42 entre deux groupes consécutifs peuvent être confondus. Un courant de rééquilibrage circule également dans ce conducteur unique, puisqu'à l'instar de l'élément de rééquilibrage 3, celui-ci relie des éléments d'interconnexion connectant une face avant à une face arrière.

### Module photovoltaïque comportant plus de quatre cellules photovoltaïques

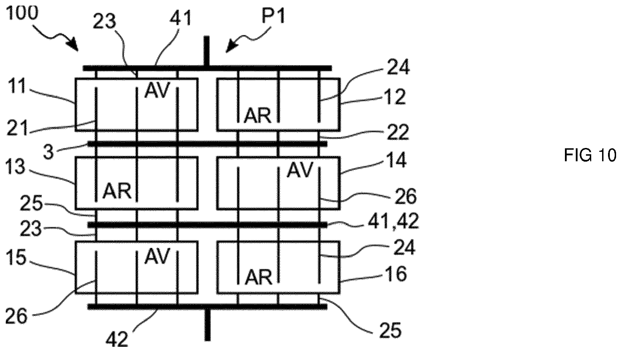

Dans le mode de réalisation de la figure 10, le module photovoltaïque 100 comporte une cinquième et une sixième cellules photovoltaïques 15, 16 dont les formes, les dimensions et les matériaux sont avantageusement identiques aux première, deuxième, troisième et quatrième cellules photovoltaïques 11, 12, 13, 14. Les cinquièmes et sixièmes cellules photovoltaïques 15, 16 comportent chacune une face avant AV et une face arrière AR opposée à la face avant AV dans lequel la face avant AV de la cinquième cellule photovoltaïque et la face arrière AR de la sixième cellule photovoltaïque sont disposées dans le premier plan P1

Les cinquièmes et sixièmes cellules photovoltaïques 15, 16 sont connectées en parallèles. Pour cela, les faces avant AV des cinquième et sixième cellules photovoltaïques 15,16 sont connectées entre elles au moyen de sixièmes et septièmes éléments conducteurs 25, 26 reliés par un élément de sortie 42. Les faces arrière AR des cinquième et sixième cellules photovoltaïques 15,16 sont connectées entres elles au moyen de quatrièmes et cinquièmes éléments conducteurs 23, 24 reliés par un élément d'entrée 41.

La paire de cellules photovoltaïques formée par les cinquièmes et sixièmes cellules photovoltaïques 15, 16 est connectée en série avec le groupe de quatre cellules photovoltaïques 11, 12, 13, 14 en connectant l'élément d'entrée 41 de la paire à l'élément de sortie 42 du groupe. De la même manière que l'assemblage de plusieurs groupes de cellules photovoltaïques décrit précédemment en relation avec la figure 9, les éléments d'entrée et de sortie 41, 42 connectés peuvent être confondus. Les éléments d'entrée et de sortie 41, 42 connectés assurent la même fonction que l'élément de rééquilibrage 3.

De façon plus générale, le module photovoltaïque peut comporter plusieurs paires de cellules photovoltaïques connectées en série avec le groupe de quatre cellules photovoltaïques 11, 12, 13, 14, de préférence de la façon décrite ci-dessus. Les cellules de chaque paire sont connectées en parallèle au moyen des éléments conducteurs et des éléments d'entrée et de sortie. L'orientation des cellules photovoltaïques alterne alors entre deux paires de cellules adjacentes, comme cela est représenté sur les figures 9 et 10.

### Procédé de fabrication d'un module photovoltaïque

Un deuxième aspect de l'invention concerne un procédé de fabrication d'un module photovoltaïque 100. Ce procédé de fabrication comprend les étapes suivantes :
- former un groupe de cellules photovoltaïques 11-14, de sorte que la face avant AV de la première cellule photovoltaïque 11, la face arrière AR de la deuxième cellule photovoltaïque 12, la face arrière AR de la troisième cellule photovoltaïque 13 et la face avant AV de la quatrième cellule photovoltaïque 14 soient disposées dans un même plan P1 :
- connecter la face avant AV de la première cellule photovoltaïque 11 avec la face arrière AR de la troisième cellule photovoltaïque 13 au moyen d'au moins un premier élément d'interconnexion 21 ;
- connecter la face avant AV de la deuxième cellule photovoltaïque 12 avec la face arrière AR de la quatrième cellule photovoltaïque 14 au moyen d'au moins un deuxième élément d'interconnexion 22 ;
- connecter le premier élément d'interconnexion 21 et le deuxième élément d'interconnexion 22 au moyen d'un élément de rééquilibrage ;
- connecter les faces arrière AR des première et deuxième cellules photovoltaïques 11, 12 ; et
- connecter les faces avant AV des troisième et quatrième cellules photovoltaïques 13, 14.

Suivant les capacités de l'équipement (« stringer ») servant à interconnecter les cellules photovoltaïques 11-14, plusieurs étapes de connexion peuvent être accomplies simultanément.

Lorsque l'élément de rééquilibrage 3 se présente sous la forme de première et deuxième parties distinctes 31, 32, l'étape de connexion des première et deuxième parties 31, 32 sur les éléments d'interconnexion 21, 22 peut être réalisée avant que les éléments d'interconnexion 21, 22 ne soient connectés aux cellules photovoltaïques 11-14. Ensuite, les deux parties distinctes 31, 32 peuvent être connectées entre elles au moyen d'un plot de connexion 33, par exemple sous la forme d'un plot d'adhésif conducteur. Alternativement, la connexion entre les deux parties 31, 32 peut être réalisée par une étape de soudage, auquel cas un matériau fusible, par exemple à base d'étain, enveloppant les première et deuxième parties 31, 32 est chauffé jusqu'à son point de fusion.

## Revendications

1. Module photovoltaïque (100) comportant un groupe de première, deuxième, troisième et quatrième cellules photovoltaïques (11, 12, 13, 14) comportant chacune une face avant (AV) et une face arrière (AR) opposée à la face avant (AV), dans lequel la face avant (AV) de la première cellule photovoltaïque (11), la face arrière (AR) de la deuxième cellule photovoltaïque (12), la face arrière (AR) de la troisième cellule photovoltaïque (13) et la face avant (AV) de la quatrième cellule photovoltaïque (14) sont disposées dans un même premier plan (P1), et dans lequel les première, deuxième, troisième et quatrième cellules photovoltaïques (11 , 12, 13, 14) sont connectées par :
- au moins un premier élément conducteur (21), dit premier élément d'interconnexion, connectant la face avant (AV) de la première cellule photovoltaïque (11) avec la face arrière (AR) de la troisième cellule photovoltaïque (13) ;
- au moins un deuxième élément conducteur (22), dit deuxième élément d'interconnexion, connectant la face avant (AV) de la deuxième cellule photovoltaïque (12) avec la face arrière (AR) de la quatrième cellule photovoltaïque (14) ;
**caractérisé en ce qu'**il comporte un troisième élément conducteur (3), dit élément de rééquilibrage, reliant le premier élément d'interconnexion (21) et le deuxième élément d'interconnexion (22) et **en ce que** les faces arrière (AR) des première et deuxième cellules photovoltaïques (11, 12) sont connectées entre elles et les faces avant (AV) des troisième et quatrième cellules photovoltaïques (13, 14) sont connectées entre elles.

2. Module photovoltaïque (100) selon la revendication 1, dans lequel les première, deuxième, troisième et quatrième cellules photovoltaïques (11, 12, 13, 14) sont sélectionnées de telle sorte que la somme du courant au point de puissance maximale généré par la première cellule photovoltaïque (11) lorsque la face avant (AV) est éclairée et du courant au point de puissance maximale généré par la deuxième cellule photovoltaïque (12) lorsque la face arrière (AR) est éclairée est sensiblement égale à la somme du courant au point de puissance maximale de la troisième cellule photovoltaïque (13) lorsque la face arrière (AR) est éclairée et du courant au point de puissance maximale de la quatrième cellule photovoltaïque (14) lorsque la face avant (AV) est éclairée.

3. Module photovoltaïque (100) selon l'une des revendications précédentes, dans lequel les première et quatrième cellules photovoltaïques (11, 14) sont sélectionnées de telle sorte que les courants aux points de puissance maximale soient sensiblement égaux lorsque leurs faces avant (AV) sont éclairées et dans lequel les deuxième et troisième cellules photovoltaïques (12, 13) sont sélectionnées de telle sorte que les courants aux points de puissance maximale soient sensiblement égaux lorsque leurs faces arrière (AR) sont éclairées.

4. Module photovoltaïque (100) selon l'une des revendications précédentes, dans lequel les première, deuxième, troisième et quatrième cellules photovoltaïques (11, 12, 13, 14) sont agencées en lignes et en colonnes, les première et deuxième cellules photovoltaïques (11, 12) appartenant à une première ligne (L1), les troisième et quatrième cellules photovoltaïques (13, 14) appartenant à une seconde ligne (L2), les première et troisième cellules photovoltaïques (11, 13) appartenant à une première colonne (C1) et les deuxième et quatrième cellules photovoltaïques (12, 14) appartenant à une deuxième colonne (C2).

5. Module photovoltaïque (100) selon l'une des revendications précédentes, dans lequel l'élément de rééquilibrage (3) est disposé entre les première et troisième cellules photovoltaïques (11, 13) et entre les deuxième et quatrième cellules photovoltaïques (12, 14).

6. Module photovoltaïque (100) selon l'une des revendications 1 à 4, dans lequel l'élément de rééquilibrage (3) est disposé sur les première et deuxième cellules photovoltaïques (11, 12) ou sur les troisième et quatrième cellules photovoltaïques (13, 14).

7. Module photovoltaïque (100) selon l'une des revendications précédentes, dans lequel les première, deuxième, troisième et quatrième cellules photovoltaïques (11, 12, 13, 14) sont de forme rectangulaire présentant un rapport longueur sur largeur compris entre 2 et 10, de préférence égal 2.

8. Module photovoltaïque (100) selon l'une des revendications 1 à 4, dans lequel les première, deuxième, troisième et quatrième cellules photovoltaïques (11, 12, 13, 14) sont de forme pseudo-carrée et l'élément de rééquilibrage (3) passe du premier plan (P1) à un deuxième plan (P2) parallèle au premier plan dans un espace central situé entre les première, deuxième, troisième et quatrième cellules photovoltaïques.

9. Module photovoltaïque (100) selon l'une des revendications précédentes, dans lequel l'élément de rééquilibrage (3) comporte une première partie (31) et une deuxième partie (32), la première partie (31) connectant le premier élément d'interconnexion (21) et la deuxième partie (32) connectant le deuxième élément d'interconnexion (22), les première et deuxième parties (31, 32) étant connectées l'une à l'autre par un plot de connexion (33) ou par une soudure.

10. Module photovoltaïque (100) selon l'une des revendications précédentes, comprenant un nombre entier N de premiers éléments d'interconnexion (21) connectant la face avant (AV) de la première cellule photovoltaïque (11) avec la face arrière (AR) de la troisième cellule photovoltaïque (13) et le même nombre entier N de deuxièmes éléments d'interconnexion (22) connectant la face avant (AV) de la deuxième cellule photovoltaïque (12) avec la face arrière (AR) de la quatrième cellule photovoltaïque (14).

11. Module photovoltaïque (100) selon la revendication précédente, dans lequel l'élément de rééquilibrage (3) connecte un nombre entier M de premiers éléments d'interconnexion (21) avec le même nombre M de deuxièmes éléments d'interconnexion (22), M étant inférieur ou égal N.

12. Module photovoltaïque (100) selon l'une des revendications précédentes, dans lequel chacun des premier (21), deuxième (22) et troisième (3, 31, 32) éléments conducteurs est constitué d'un fil conducteur ou d'un ruban conducteur.

13. Module photovoltaïque (100) selon l'une des revendications précédentes, comprenant une cinquième et une sixième cellules photovoltaïques comportant chacune une face avant (AV) et une face arrière (AR) opposée à la face avant (AV), dans lequel la face avant (AV) de la cinquième cellule photovoltaïque et la face arrière (AR) de la sixième cellule photovoltaïque sont disposées dans le premier plan (P1), les faces avant (AV) des cinquième et sixième cellules photovoltaïques sont connectées entre elles et les faces arrière (AR) des cinquième et sixième cellules photovoltaïques sont connectées entres elles aux faces avant (AV) des troisième et quatrième cellules photovoltaïques (13, 14).

14. Procédé de fabrication d'un module photovoltaïque (100) selon l'une des revendications précédentes, comportant les étapes suivantes :
- Former un groupe de première, deuxième, troisième et quatrième cellules photovoltaïques (11, 12, 13, 14) comportant chacune une face avant (AV) et une face arrière (AR) opposée à la face avant (AV);
- Arranger les première, deuxième, troisième et quatrième cellules photovoltaïques (11, 12, 13, 14) telles que la face avant (AV) de la première cellule photovoltaïque (11), la face arrière (AR) de la deuxième cellule photovoltaïque (12), la face arrière (AR) de la troisième cellule photovoltaïque (13) et la face avant (AV) de la quatrième cellule photovoltaïque (14) soient disposées dans un même premier plan (P1) ;
- Connecter la face avant (AV) de la première cellule photovoltaïque (11) avec la face arrière (AR) de la troisième cellule photovoltaïque (13) au moyen d'au moins un premier élément conducteur (21), dit premier élément d'interconnexion ;
- Connecter la face avant (AV) de la deuxième cellule photovoltaïque (12) avec la face arrière (AR) de la quatrième cellule photovoltaïque (14) au moyen d'au moins un deuxième élément conducteur (22), dit deuxième élément d'interconnexion ;
- Connecter le premier élément d'interconnexion (21) et le deuxième élément d'interconnexion (22) au moyen d'un troisième élément conducteur (3), dit élément de rééquilibrage ;
- Connecter les faces arrière (AR) des première et deuxième cellules photovoltaïques (11, 12) ; et
- Connecter les faces avant (AV) des troisième et quatrième cellules photovoltaïques (13, 14).

15. Procédé de fabrication d'un module photovoltaïque (100) selon la revendication précédente, dans lequel l'étape de connexion du premier élément d'interconnexion (21) et du deuxième élément d'interconnexion (22), comporte les sous-étapes suivantes :
- Prévoir un élément de rééquilibrage (3) comportant une première partie (31) et une deuxième parties (32) distinctes ;
- Connecter la première partie (31) de l'élément de rééquilibrage (3) avec le premier élément d'interconnexion (21) ;
- Connecter la deuxième partie (32) de l'élément de rééquilibrage (3) avec le deuxième élément d'interconnexion (22) ;
- Connecter la première partie (31) de l'élément de rééquilibrage (3) avec la deuxième partie (32) de l'élément de rééquilibrage (3) au moyen d'un plot de connexion (33) ou d'une soudure.

## Patentansprüche

1. Fotovoltaikmodul (100) mit einer Gruppe aus erster, zweiter, dritter und vierter Solarzelle (11, 12, 13, 14), die jeweils eine Vorderseite (AV) und eine ihr gegenüberliegende Rückseite (AR) umfassen, in dem die Vorderseite (AV) der ersten Solarzelle (11), die Rückseite (AR) der zweiten Solarzelle (12), die Rückseite (AR) der dritten Solarzelle (13) und die Vorderseite (AV) der vierten Solarzelle (14) in einer ersten gleichen Ebene (P1) angeordnet sind, und in dem die erste, zweite, dritte und vierte Solarzelle (11,12,13,14) miteinander verbunden sind durch:
- mindestens ein erstes leitfähiges Element (21), als erstes Verbindungselement bezeichnet, das die Vorderseite (AV) der ersten Solarzelle (11) mit der Rückseite (AR) der dritten Solarzelle (13) verbindet;
- mindestens ein zweites leitfähiges Element (22), als zweites Verbindungselement bezeichnet, das die Vorderseite (AV) der zweiten Solarzelle (12) mit der Rückseite (AR) der vierten Solarzelle (14) verbindet;
**dadurch gekennzeichnet, dass** es ein drittes leitfähiges Element (3) umfasst, als Ausgleichselement bezeichnet, das das erste Verbindungselement (21) und das zweite Verbindungselement (22) miteinander verbindet, und dadurch, dass die Rückseiten (AR) der ersten und zweiten Solarzelle (11,12) miteinander verbunden sind und die Vorderseiten (AV) der dritten und vierten Solarzelle (13, 14) ebenfalls miteinander verbunden sind.

2. Fotovoltaikmodul (100) nach Anspruch 1, bei dem die erste, zweite, dritte und vierte Solarzelle (11,12,13,14) derart ausgewählt werden, dass die Summe des Stroms am von der ersten Solarzelle (11) generierten höchsten Leistungspunkt, wenn die Vorderseite (AV) beleuchtet wird, und des Stroms am von der zweiten Solarzelle (12) generierten höchsten Leistungspunkt, wenn die Rückseite beleuchtet wird, in etwa der Summe des Stroms am höchsten Leistungspunkt der dritten Solarzelle (13), wenn die Rückseite (AR) beleuchtet wird, und des Stroms am höchsten Leistungspunkt der vierten Solarzelle (14), wenn die Vorderseite (AV) beleuchtet wird, entspricht.

3. Fotovoltaikmodul (100) nach einem der vorausgehenden Ansprüche, bei dem die erste und vierte Solarzelle (11,14) derart ausgewählt werden, dass die Ströme an den höchsten Leistungspunkten in etwa gleich sind, wenn ihre Vorderseiten (AV) beleuchtet werden, und bei dem die zweite und dritte Solarzelle (12,13) derart ausgewählt werden, dass die Ströme an den höchsten Leistungspunkten in etwa gleich sind, wenn ihre Rückseiten (AR) beleuchtet werden.

4. Fotovoltaikmodul (100) nach einem der vorausgehenden Ansprüche, bei dem die erste, zweite, dritte und vierte Solarzelle (11,12,13,14) in Reihe und in Säulen angeordnet sind, wobei die erste und zweite Solarzelle (11,12) einer ersten Reihe (L1) angehören, die dritte und vierte Solarzelle (13,14) einer zweiten Reihe (L2) angehören, die erste und dritte Solarzelle (11,13) einer ersten Säule (C1) und die zweite und vierte Solarzelle (12, 14) einer zweiten Säule (C2) angehören.

5. Fotovoltaikmodul (100) nach einem der vorausgehenden Ansprüche, bei dem das Ausgleichselement (3) zwischen der ersten und dritten Solarzelle (11,13) und zwischen der zweiten und vierten Solarzelle (12,14) angeordnet ist.

6. Fotovoltaikmodul (100) nach einem der Ansprüche 1 bis 4, bei dem das Ausgleichselement (3) auf der ersten und zweiten Solarzelle (11,12) oder auf der dritten und vierten Solarzelle (13,14) angeordnet ist.

7. Fotovoltaikmodul (100) nach einem der vorausgehenden Ansprüche, bei dem die erste, zweite, dritte und vierte Solarzelle (11,12,13,14) rechteckig sind und ein Längen-/Breiten-Verhältnis zwischen 2 und 10 aufweisen, vorzugsweise ein Verhältnis von 2.

8. Fotovoltaikmodul (100) nach einem der Ansprüche 1 bis 4, bei dem die erste, zweite, dritte und vierte Solarzelle (11,12,13,14) pseudoquadratisch sind und das Ausgleichselement (3) von der ersten Ebene (P1) auf eine zweite zur ersten Ebene parallele Ebene (P2) übergeht, die sich in einem zentralen Raum zwischen der ersten, zweiten, dritten und vierten Solarzelle befindet.

9. Fotovoltaikmodul (100) nach einem der vorausgehenden Ansprüche, bei dem das Ausgleichselement (3) einen ersten Abschnitt (31) und einen zweiten Abschnitt (32) umfasst, wobei der erste Abschnitt (31) die Verbindung zum Verbindungselement (21) herstellt und der zweite Abschnitt (32) die Verbindung zum Verbindungselement (22) herstellt, und wobei der erste und zweite Abschnitt (31,32) durch eine Lötstelle (33) oder einen Schweißpunkt miteinander verbunden sind.

10. Fotovoltaikmodul (100) nach einem der vorausgehenden Ansprüche, eine ganze Zahl N von ersten Verbindungselementen (21) umfassend, die die Vorderseite (AV) der ersten Solarzelle (11) mit der Rückseite (AR) der dritten Solarzelle (13) verbinden, und die gleiche ganze Zahl N von zweiten Verbindungselementen (22) umfassend, die die Vorderseite (AV) der zweiten Solarzelle (12) mit der Rückseite (AR) der vierten Solarzelle (14) verbinden.

11. Fotovoltaikmodul (100) nach vorausgehendem Anspruch, bei dem das Ausgleichselement (3) eine ganze Zahl M von ersten Verbindungselementen (21) mit der gleichen Zahl M von zweiten Verbindungselementen (22) verbindet, wobei M kleiner gleich N ist.

12. Fotovoltaikmodul (100) nach einem der vorausgehenden Ansprüche, bei dem jeweils das erste (21), zweite (22) und dritte leitfähige Element (3,31,32) aus einem leitfähigen Draht oder einem leitfähigen Band bestehen.

13. Fotovoltaikmodul (100) nach einem der vorausgehenden Ansprüche, eine fünfte und eine sechste Solarzelle umfassend, die jeweils eine Vorderseite (AV) und eine dieser Vorderseite (AV) gegenüberliegende Rückseite (AR) umfassen, bei dem die Vorderseite (AV) der fünften Solarzelle und die Rückseite (AR) der sechsten Solarzelle in der ersten Ebene (P1) angeordnet sind, wobei die Vorderseiten (AV) der fünften und sechsten Solarzelle miteinander verbunden sind und die Rückseiten (AR) der fünften und sechsten Solarzelle mit den Vorderseiten (AV) der dritten und vierten Solarzelle (13,14) miteinander verbunden sind.

14. Fertigungsverfahren für ein Fotovoltaikmodul (100) nach einem der vorausgehenden Ansprüche, mit folgenden Arbeitsschritten:
- Bilden einer Gruppe aus erster, zweiter, dritter und vierter Solarzelle (11,12,13,14), die jeweils eine Vorderseite (AV) und eine der Vorderseite (AV) gegenüberliegende Rückseite (AR) aufweisen;
- erste, zweite, dritte und vierte Solarzelle (11,12,13,14) derart anordnen, dass die Vorderseite (AV) der ersten Solarzelle (11), die Rückseite (AR) der zweiten Solarzelle (12), die Rückseite (AR) der dritten Solarzelle (13) und die Vorderseite (AV) der vierten Solarzelle (14) in einer gleichen ersten Ebene (P1) angeordnet sind;
- Verbinden der Vorderseite (AV) der ersten Solarzelle (11) mit der Rückseite (AR) der dritten Solarzelle (13) anhand von mindestens einem ersten leitfähigen Element (21), das als erstes Verbindungselement bezeichnet wird;
- Verbinden der Vorderseite (AV) der zweiten Solarzelle (12) mit der Rückseite (AR) der vierten Solarzelle (14) anhand von mindestens einem zweiten leitfähigen Element (22), das als zweites Verbindungselement bezeichnet wird;
- Verbinden des ersten Verbindungselements (21) und des zweiten Verbindungselements (22) anhand eines dritten leitfähigen Elements (3), das als Ausgleichselement bezeichnet wird;
- Verbinden der Rückseiten (AR) der ersten und zweiten Solarzelle (11,12); und
- Verbinden der Vorderseiten (AV) der dritten und vierten Solarzelle (13,14).

15. Fertigungsverfahren für ein Fotovoltaikmodul (100) nach vorausgehendem Anspruch, bei dem der Arbeitsschritt des Verbindens des ersten Verbindungselements (21) und des zweiten Verbindungselements (22) folgende Unterschritte umfasst:
- Vorsehen eines Ausgleichselements (3), das einen separaten ersten Abschnitt (31) und einen separaten zweiten Abschnitt (32) umfasst;
- Verbinden des ersten Abschnitts (31) des Ausgleichselements (3) mit dem ersten Verbindungselement (21) ;
- Verbinden des zweiten Abschnitts (32) des Ausgleichselements (3) mit dem zweiten Verbindungselement (22) ;
- Verbinden des ersten Abschnitts (31) des Ausgleichselements (3) mit dem zweiten Abschnitt (32) des Ausgleichselements (3) anhand einer Lötstelle (33) oder eines Schweißpunkts.

## Claims

1. A photovoltaic module (100) including a group of first, second, third and fourth photovoltaic cells (11, 12, 13, 14) each including a front face (AV) and a rear face (AR) opposite to the front face (AV), wherein the front face (AV) of the first photovoltaic cell (11), the rear face (AR) of the second photovoltaic cell (12), the rear face (AR) of the third photovoltaic cell (13) and the front face (AV) of the fourth photovoltaic cell (14) are disposed in a same first plane (P1), and wherein the first, second, third and fourth photovoltaic cells (11, 12, 13, 14) are connected by:
- at least one first conductor element (21), called a first interconnection element, connecting the front face (AV) of the first photovoltaic cell (11) with the rear face (AR) of the third photovoltaic cell (13);
- at least one second conductor element (22), called a second interconnection element, connecting the front face (AV) of the second photovoltaic cell (12) with the rear face (AR) of the fourth photovoltaic cell (14);
**characterised in that** it includes a third conductor element (3), called a rebalancing element, connecting the first interconnection element (21) and the second interconnection element (22) and **in that** the rear faces (AR) of the first and second photovoltaic cells (11, 12) are connected to each other and the front faces (AV) of the third and fourth photovoltaic cells (13, 14) are connected to each other.

2. The photovoltaic module (100) according to claim 1, wherein the first, second, third and fourth photovoltaic cells (11, 12, 13, 14) are selected so that the sum of the current at the maximum power point generated by the first photovoltaic cell (11) when the front face (AV) is lit and of the current at the maximum power point generated by the second photovoltaic cell (12) when the rear face (AR) is lit is substantially equal to the sum of the current at the maximum power point of the third photovoltaic cell (13) when the rear face (AR) is lit and of the current at the maximum power point of the fourth photovoltaic cell (14) when the front face (AV) is lit.

3. The photovoltaic module (100) according to one of the preceding claims, wherein the first and fourth photovoltaic cells (11, 14) are selected so that the currents at the maximum power points are substantially equal when their front faces (AV) are lit and wherein the second and third photovoltaic cells (12, 13) are selected so that the currents at the maximum power points are substantially equal when their rear faces (AR) are lit.

4. The photovoltaic module (100) according to one of the preceding claims, wherein the first, second, third and fourth photovoltaic cells (11, 12, 13, 14) are arranged in rows and columns, the first and second photovoltaic cells (11, 12) belonging to a first row (L1), the third and fourth photovoltaic cells (13, 14) belonging to a second row (L2), the first and third photovoltaic cells (11, 13) belonging to a first column (C1) and the second and fourth photovoltaic cells (12, 14) belonging to a second column (C2).

5. The photovoltaic module (100) according to one of the preceding claims, wherein the rebalancing element (3) is disposed between the first and third photovoltaic cells (11, 13) and between the second and fourth photovoltaic cells (12, 14).

6. The photovoltaic module (100) according to one of claims 1 to 4, wherein the rebalancing element (3) is disposed on the first and second photovoltaic cells (11, 12) or on the third and fourth photovoltaic cells (13, 14).

7. The photovoltaic module (100) according to one of the preceding claims, wherein the first, second, third and fourth photovoltaic cells (11, 12, 13, 14) are rectangular in shape having a length to width ratio of between 2 and 10, preferably equal to 2.

8. The photovoltaic module (100) according to one of claims 1 to 4, wherein the first, second, third and fourth photovoltaic cells (11, 12, 13, 14) are pseudosquared in shape and the rebalancing element (3) passes from the first plane (P1) to a second plane (P2) parallel to the first plane in a central space located between the first, second, third and fourth photovoltaic cells.

9. The photovoltaic module (100) according to one of the preceding claims, wherein the rebalancing element (3) includes a first part (31) and a second part (32), the first part (31) connecting the first interconnection element (21) and the second part (32) connecting the second interconnection element (22), the first and second parts (31, 32) being connected to each other through a connection pad (33) or through a weld.

10. The photovoltaic module (100) according to one of the preceding claims, comprising an integer N of first interconnection elements (21) connecting the front face (AV) of the first photovoltaic cell (11) with the rear face (AR) of the third photovoltaic cell (13) and the same integer N of second interconnection elements (22) connecting the front face (AV) of the second photovoltaic cell (12) with the rear face (AR) of the fourth photovoltaic cell (14).

11. The photovoltaic module (100) according to one of the preceding claims, wherein the rebalancing element (3) connects an integer M of first interconnection elements (21) with the same integer M of second interconnection elements (22), M being less than or equal to N.

12. The photovoltaic module (100) according to one of the preceding claims, wherein each of the first (21), second (22) and third (3, 31, 32) conductor elements consists of a conducting wire or a conducting tape.

13. The photovoltaic module (100) according to one of the preceding claims, comprising a fifth and a sixth photovoltaic cells each including a front face (AV) and a rear face (AR) opposite to the front face (AV), wherein the front face (AV) of the fifth photovoltaic cell and the rear face (AR) of the sixth photovoltaic cell are disposed in the first plane (P1), the front faces (AV) of the fifth and sixth photovoltaic cells are connected to each other and the rear faces (AR) of the fifth and sixth photovoltaic cells are connected to each other at the front faces (AV) of the third and fourth photovoltaic cells (13, 14).

14. A method for manufacturing a photovoltaic module (100) according to one of the preceding claims, including the following steps of:
- forming a group of first, second, third and fourth photovoltaic cells (11, 12, 13, 14) each including a front face (AV) and a rear face (AR) opposite to the front face (AV);
- arranging the first, second, third and fourth photovoltaic cells (11, 12, 13, 14) so that the front face (AV) of the first photovoltaic cell (11), the rear face (AR) of the second photovoltaic cell (12), the rear face (AR) of the third photovoltaic cell (13) and the front face (AV) of the fourth photovoltaic cell (14) are disposed in a same first plane (P1);
- connecting the front face (AV) of the first photovoltaic cell (11) with the rear face (AR) of the third photovoltaic cell (13) by means of at least one first conductor element (21), called a first interconnection element;
- connecting the front face (AV) of the second photovoltaic cell (12) with the rear face (AR) of the fourth photovoltaic cell (14) by means of at least one second conductor element (22), called a second interconnection element;
- connecting the first interconnection element (21) and the second interconnection element (22) by means of a third conductor element (3), called a rebalancing element;
- connecting the rear faces (AR) of the first and second photovoltaic cells (11, 12); and
- connecting the front faces (AV) of the third and fourth photovoltaic cells (13, 14).

15. The method for manufacturing a photovoltaic module (100) according to the preceding claim, wherein the step of connecting the first interconnection element and the second interconnection element, includes the following substeps of:
- providing a rebalancing element (3) including a first part (31) and a second part (32) being distinct;
- connecting the first part (31) of the rebalancing element (3) with the first interconnection element (21);
- connecting the second part (32) of the rebalancing element (3) with the second interconnection element (22);
- connecting the first part (31) of the rebalancing element (3) with the second part (32) of the rebalancing element (3) by means of a connection pad (33) or of a weld.
